# EUROPEAN PATENT SPECIFICATION

(11) **EP 4 148 714 B1**
(45) Date of publication and mention of the grant of the patent: **23.04.2025**
(21) Application number: 22189375.3
(22) Date of filing: 09.08.2022
(51) Int. Cl.: G09F 9/302

(54) **TENSIONING MECHANISM OF BOX AND LED BOX ASSEMBLY WITH TENSIONING MECHANISM OF BOX**
SPANNUNGSMECHANISMUS DER BOX UND LED-BOX-ANORDNUNG MIT SPANNUNGSMECHANISMUS DER BOX
MÉCANISME DE MISE EN TENSION DE BOÎTE ET ENSEMBLE BOÎTIER DE DEL AVEC MÉCANISME DE MISE EN TENSION DE BOÎTE

(30) Priority: 07.09.2021 CN 202111044721
(43) Date of publication of application: 15.03.2023
(73) Proprietor: Shenzhen Leyard Opto-Electronic Co., Ltd., Shenzhen Guangdong 518110 (CN)
(72) Inventor: LI, Bingfeng, Shenzhen, 518110 (CN); GAN, Xiangang, Shenzhen, 518110 (CN)
(74) Representative: De Clercq & Partners

(56) References cited:
- WO-A1-2020/134384
- CN-B- 102 711 402
- CN-U- 205 559 457
- US-A1- 2008 263 924

## Description

### Technical Field

The present invention relates to a technical field of light emitting diode (LED) display, and in particular to a tensioning mechanism of a box and an LED box assembly with the tensioning mechanism of the box.

### Background

A light emitting diode (LED) display screen includes a box assembly and a display screen mounted on the box assembly. The box assembly is assembled from a plurality of boxes. During field mounting, assembled boxes are deformed obviously, and there is a gap between two adjacent boxes, so display quality of the LED display screen is seriously affected. There is provided a tensioning mechanism in the related technology, by which the two adjacent boxes can be tensioned close to reduce the gap.

The tensioning mechanism includes a connection column connected withwith a box and a tensioning seat connected with another box. The connection column passes through the tensioning seat and is in threaded cooperation with a tensioning nut. The connecting column is sleeved with a spring. The spring is located between the tensioning seat and the tensioning nut. The tensioning nut is provided with a plurality of operation holes. An operation rod, an external tool, passes through an operation hole to screw the tensioning nut so as to apply a force to the spring, so that the tensioning nut is pressed on the connection column, and further the two adjacent boxes are tensioned close.

But the external tool is required for tensioning the two adjacent boxes close, resulting in a complex tensioning process. In addition, usage of the external tool leads to high cost of the LED display screen.

Examples of a bolt-type connecting device according to the prior art are known from WO 2020/134384 A1. And Examples of a connecting device for an LED display module according to the prior art are known from CN 102711402 B.

### Summary

A main objective of the present invention is to provide a tensioning mechanism of a box and a light emitting diode (LED) box assembly with the tensioning mechanism of the box, so as to solve the problem that in the related technology, an external tool is required for tensioning two adjacent boxes close, resulting in a complex tensioning process.

The invention is as defined in claim 1.

To achieve the objective, an aspect of the present invention provides a tensioning mechanism of a box. The tensioning mechanism of a box includes a tensioning structure including a base and a tensioning rod, wherein the base is provided with a mounting portion, the tensioning rod includes a tensioning pin and an operating portion connected with the tensioning pin, and the tensioning pin is movably arranged in the mounting portion in a penetrating manner; and a connecting member provided with a cooperating hole, wherein the tensioning pin includes a flat shaft, the flat shaft is able to being inserted into or moved out of the cooperating hole, and under the condition that the flat shaft is inserted into the cooperating hole, the flat shaft has a vertical tensioning position and a transverse unlocking position.

In some embodiments, the mounting portion is a mounting groove, the tensioning structure further includes a limiting member, and the limiting member is connected with the base and located at an opening of the mounting groove.

In the invention, the tensioning pin further includes a cooperating section arranged between the flat shaft and the operating portion, the tensioning structure further includes a positioning structure arranged between the cooperating section and the base, and the positioning structure enables the flat shaft to be kept at an insertion position for inserting into the cooperating hole or a move-out position for moving out of the cooperating hole.

In the invention, the positioning structure includes a positioning member, a first positioning hole and a second positioning hole, the first positioning hole is located between the second positioning hole and the flat shaft, the cooperating section is provided with the first positioning hole and the second positioning hole, the base is provided with the positioning member, when the positioning member cooperates the first positioning hole, the flat shaft is kept at the insertion position, and when the positioning member cooperates the second positioning hole, the flat shaft is kept at the move-out position.

In some embodiments, the positioning structure further includes a limiting hole provided on the base, the positioning member includes an elastic member and a positioning ball which are mounted in the limiting hole, the elastic member applies an elastic force to the positioning ball, a diameter of the first positioning hole and a diameter of the second positioning hole are both smaller than that of the positioning ball, and when the tensioning pin moves, a part of the positioning ball has a positioning position located in the first positioning hole or the second positioning hole and an avoiding position for avoiding the flat shaft.

In some embodiments, the base includes a base body as well as a first avoiding notch and a second avoiding notch which are arranged on the base body in a spaced manner, the first avoiding notch is located between the second avoiding notch and the flat shaft, the mounting portion is arranged on the base body, the first avoiding notch and the second avoiding notch are both located at one side of the mounting portion, when a part of the operating portion is located in the first avoiding notch, the flat shaft is located at the insertion position, and when a part of the operating portion is located in the second avoiding notch, the flat shaft is located at the move-out position.

In some embodiments, the tensioning rod is arranged in a bent manner so as to form the tensioning pin and the operating portion; and the limiting member includes a limiting piece.

In some embodiments, the connecting member includes a columnar section and a threaded section connected with the columnar section, a diameter of the columnar section is larger than that of the threaded section, the cooperating hole is provided on the columnar section, the columnar section is provided with a rotation stopping face, and a diameter of the flat shaft is smaller than that of the cooperating hole.

Another aspect of the present invention provides a LED box assembly, which includes a plurality of boxes and the above-mentioned tensioning mechanism of the box.

In some embodiments, the plurality of boxes cooperate one another in a spliced manner, there are a plurality of tensioning mechanisms for boxes, in the two boxes connected one above the other, one of the boxes is a first box and the other is a second box, and each of the first box and the second box includes a first side, a second side, a third side and a fourth side which are sequentially connected with one another; and the third side of the first box is connected with the first side of the second box by one of the tensioning mechanisms for boxes, the tensioning structure is arranged at the third side of the first box, the connecting member is arranged on the first side of the second box in a penetrating manner, and the third side of the first box is provided with an avoiding hole for avoiding the connecting member on the second box.

According to the technical solution of the present invention, the tensioning mechanism of a box includes the tensioning structure and the connecting member. The tensioning structure includes the base and the tensioning rod. The base is provided with the mounting portion, and the tensioning rod includes the tensioning pin and the operating portion connected with the tensioning pin. In this way, the operating portion enables the mounting personnel to conveniently conduct operations on the tensioning rod. The tensioning pin is movably arranged in the mounting portion in a penetrating manner. The connecting member is provided with the cooperating hole. In the disclosure, the tensioning pin includes the flat shaft, and the flat shaft is capable of being inserted into or moved out of the cooperating hole. Under the condition that the flat shaft is inserted into the cooperating hole, the flat shaft has the vertical tensioning position and the transverse unlocking position. Under the condition that the flat shaft is inserted into the cooperating hole, the flat shaft is capable of applying a force to a hole wall of the cooperating hole when being at the vertical tensioning position, and the flat shaft is incapable of applying a force to the hole wall of the cooperating hole when being at the transverse unlocking position. When two adjacent boxes are tensioned close, the connecting member may be connected with one of the boxes, the tensioning structure is connected with the other box, the tensioning rod is moved, then the flat shaft is inserted into the cooperating hole, the flat shaft is switched from the transverse unlocking position to the vertical tensioning position, and in this case, the flat shaft applies a force to the hole wall of the cooperating hole, so as to tension the two adjacent boxes close. Thus, when the two adjacent boxes are tensioned close, the two adjacent boxes may be tensioned close without an external tool (operation rod), thus simplifying a tensioning process and further reducing a gap. Therefore, the technical solution of the disclosure effectively solves the problem that in the related technology, an external tool is required for tensioning two adjacent boxes close, resulting in a complex tensioning process.

### Brief Description of the Drawings

The drawings of the description, which form a part of the disclosure, are used to provide further understanding of the present invention, and illustrative embodiments of the present invention and the description thereof are used to explain the present invention, which are not intended to unduly limit the present invention. In the drawings:
Fig. 1 shows a schematic diagram of a stereostructure of an embodiment of the tensioning mechanism of the box according to the present invention, in which a tensioning structure and a connecting member are mounted on a box;
Fig. 2 shows a schematic diagram of a local structure of the tensioning mechanism of the box in Fig. 1;
Fig. 3 shows a schematic diagram of a stereostructure of the connecting member of the tensioning mechanism of the box in Fig. 1;
Fig. 4 shows a schematic diagram of a stereostructure of the tensioning mechanism of the box in Fig. 1, in which the tensioning structure is mounted on the box;
Fig. 5 shows an enlarged schematic diagram of portion A of the tensioning mechanism of the box in Fig. 4;
Fig. 6 shows a schematic diagram of a stereostructure of the tensioning mechanism of a box in Fig. 1, in which the tensioning rod removed from the box;
Fig. 7 shows an enlarged schematic diagram of portion B of the tensioning mechanism of the box in Fig. 6;
Fig. 8 shows a schematic diagram of a local section view of the tensioning mechanism of the box in Fig. 7;
Fig. 9 shows a schematic diagram of a stereostructure of an embodiment of a light emitting diode (LED) box assembly according to the present invention;
Fig. 10 shows an enlarged schematic diagram of portion C of the LED box assembly in Fig. 9;
Fig. 11 shows an enlarged schematic diagram of portion D of the LED box assembly in Fig. 9; and
Fig. 12 shows an enlarged schematic diagram of portion E of the LED box assembly in Fig. 9.

The above drawings include the following reference numerals:
10: tensioning structure; 11: base; 111: mounting portion; 112: limiting hole; 113: base body; 1131: first avoiding notch; 1132: second avoiding notch; 12: tensioning rod; 121: tensioning pin; 1211: flat shaft; 1212: cooperating section; 122: operating portion; 13: limiting member; 14: positioning structure; 141: first positioning hole; 142: positioning member; 1421: elastic member; 1422: positioning ball; 143: second positioning hole; 20: connecting member; 21: cooperating hole; 22: columnar section; 221: rotation stopping face; 23: threaded section; 30: box; 31: first side; 331: avoiding hole; 32: second side; 33: third side; and 34: fourth side.

### Detailed Description of the Embodiments

The technical solutions in the embodiments of the present invention are clearly and completely described below with reference to the accompanying drawings in the embodiments of the present invention. Apparently, the described embodiments are merely a part rather than all of the embodiments of the present invention.

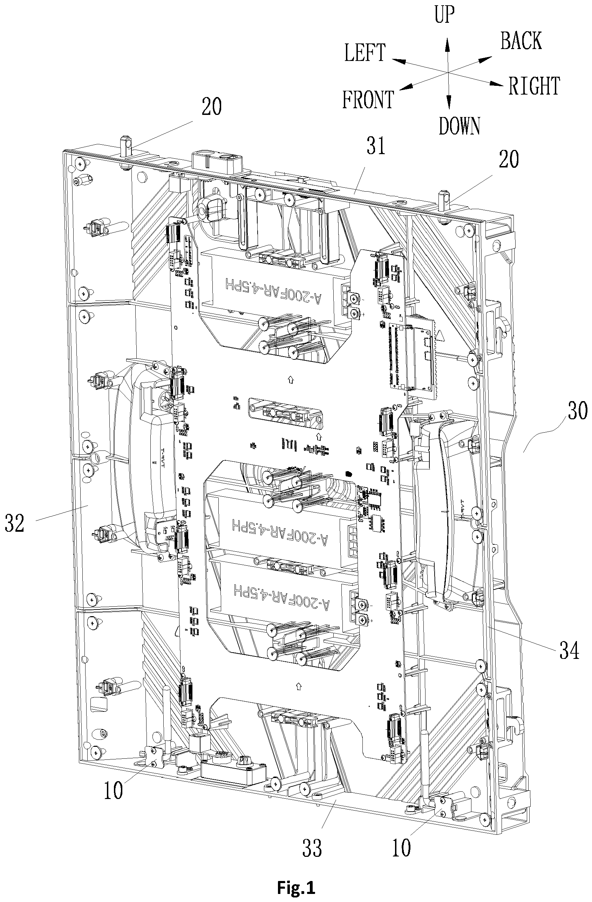

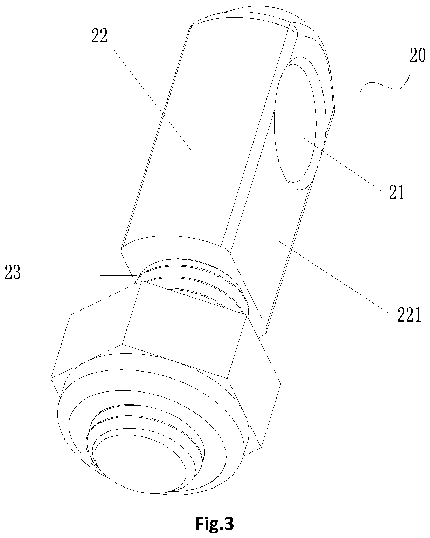

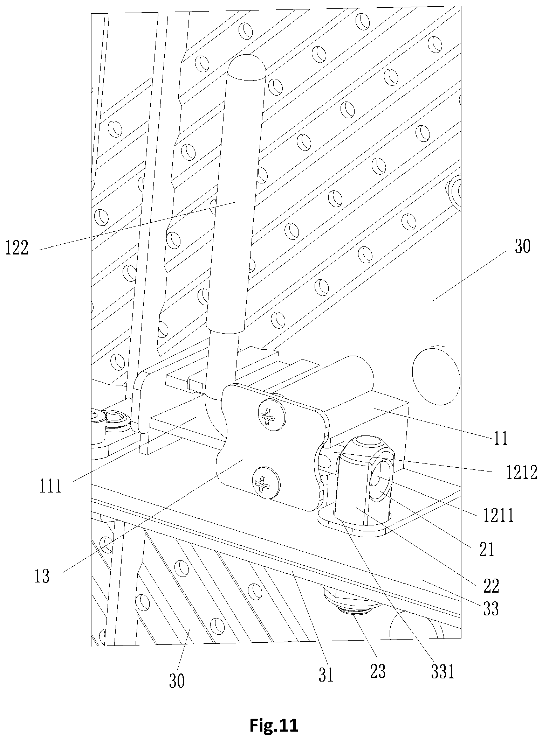

As shown in Figs. 1-5 and Fig. 11, a tensioning mechanism of a box of the embodiment includes a tensioning structure 10 and a connecting member 20. The tensioning structure 10 includes a base 11 and a tensioning rod 12. The base 11 is provided with a mounting portion 111, and the tensioning rod 12 includes a tensioning pin 121 and an operating portion 122 connected with the tensioning pin 121. The tensioning pin 121 is movably arranged in the mounting portion 111 in a penetrating manner. The connecting member 20 is provided with a cooperating hole 21. In the embodiment, the tensioning pin 121 includes a flat shaft 1211, and the flat shaft 1211 is capable of being inserted into or moved out of the cooperating hole 21. Under the condition that the flat shaft 1211 is inserted into the cooperating hole 21, the flat shaft 1211 has a vertical tensioning position and a transverse unlocking position.

According to the technical solution of the embodiment, the tensioning rod 12 includes the tensioning pin 121 and the operating portion 122 connected with the tensioning pin 121. In this way, the operating portion 122 enables the mounting personnel to conveniently conduct operations on the tensioning rod 12. In the embodiment, the tensioning pin 121 includes the flat shaft 1211, and the flat shaft 1211 is capable of being inserted into or moved out of the cooperating hole 21. Under the condition that the flat shaft 1211 is inserted into the cooperating hole 21, the flat shaft 1211 has the vertical tensioning position and the transverse unlocking position. Under the condition that the flat shaft 1211 is inserted into the cooperating hole 21, the flat shaft 1211 is capable of applying a force upwardly to a hole wall of the cooperating hole 21 when the flat shaft 1211 is at the vertical tensioning position, and the flat shaft 1211 is incapable of applying a force to the hole wall of the cooperating hole 21 when the flat shaft 1211 is at the transverse unlocking position. When two adjacent boxes are tensioned close, the connecting member 20 may be connected with one of the boxes, the tensioning structure 10 is connected with the other box, the tensioning rod 12 is moved, then the flat shaft 1211 is inserted into the cooperating hole 21, at this time, the flat shaft 1211 is at the transverse unlocking position, then the flat shaft 1211 is switched from the transverse unlocking position to the vertical tensioning position, and in this case, the flat shaft 1211 applies a force upwardly to the hole wall of the cooperating hole 21, so as to tension the two adjacent boxes close. Thus, when the two adjacent boxes are tensioned close, the two adjacent boxes may be tensioned close without an external tool (operation rod), thus simplifying a tensioning process and then reducing a gap. Therefore, the technical solution of the embodiment effectively solves the problem that in the related technology, an external tool is required for tensioning two adjacent boxes close, resulting in a complex tensioning process.

It should be noted that the flat shaft 1211 of the embodiment has a long axis A1 and a short axis A2, the vertical tensioning position means that the long axis A1 of the flat shaft 1211 is vertical, and the transverse unlocking position means that the short axis A2 of the flat shaft 1211 is vertical. The flat shaft 1211 switches between the transverse unlocking position and the vertical tensioning position by rotation.

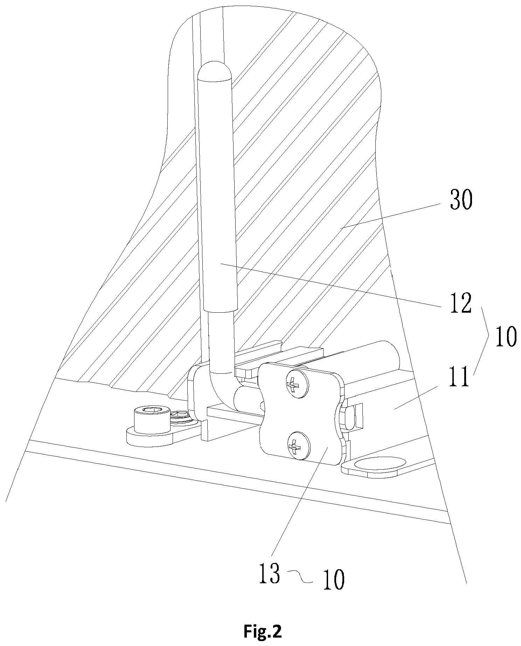

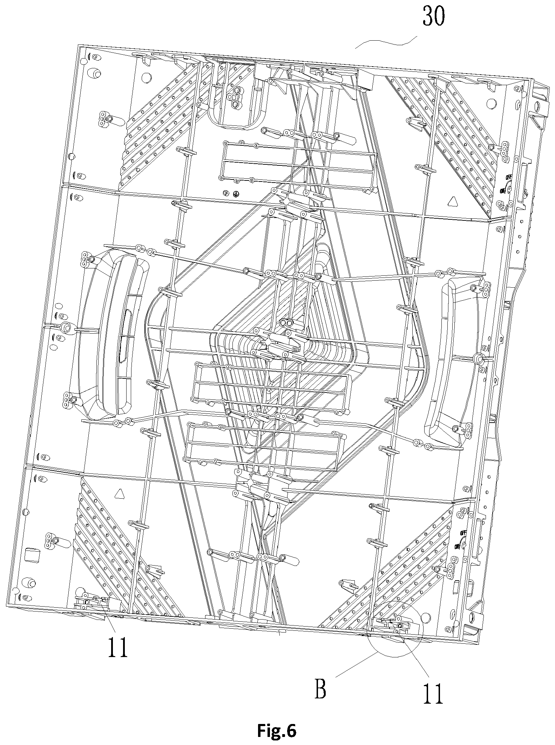

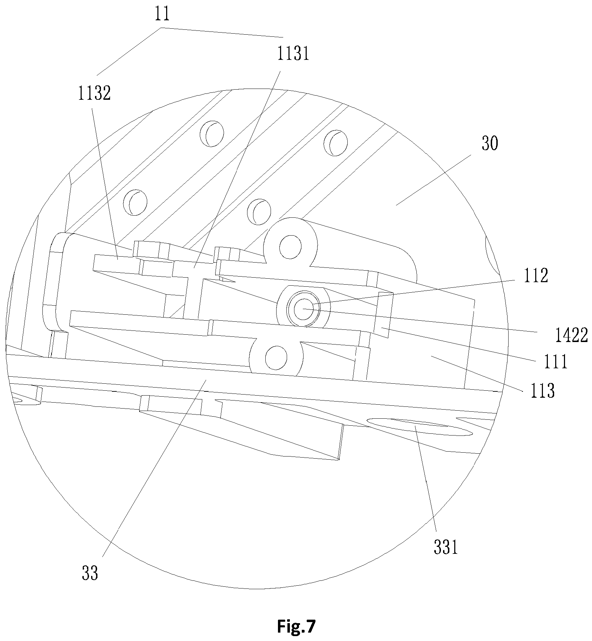

As shown in Figs. 2-7, to facilitate machining and shaping, the mounting portion 111 is a mounting groove. The tensioning structure 10 further includes a limiting member 13, and the limiting member 13 is connected with the base 11 and located at an opening of the mounting groove. The limiting member 13 is capable of limiting the tensioning rod 12 on the mounting groove, so as to prevent the tensioning pin 121 from being separated from the mounting groove during movement in the mounting groove.

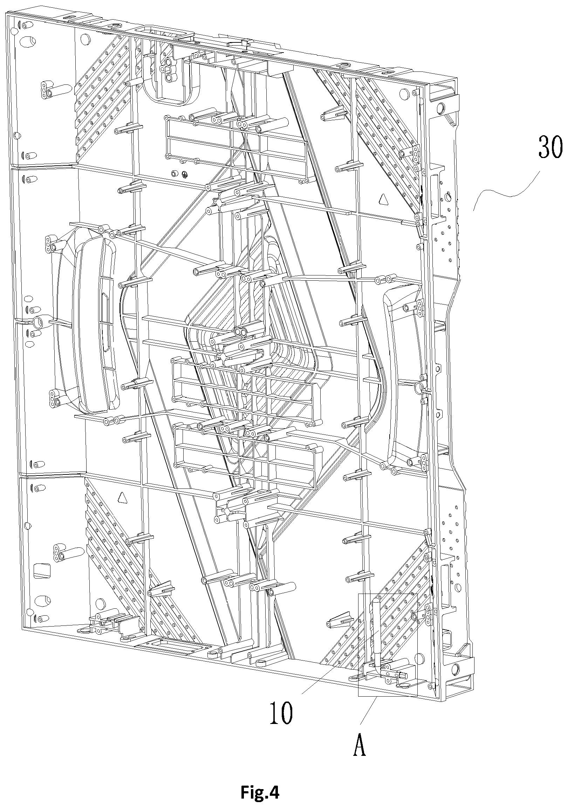

As shown in Figs. 4-7, the tensioning pin 121 further includes a cooperating section 1212 arranged between the flat shaft 1211 and the operating portion 122. The flat shaft 1211 and the operating portion 122 are connected with two ends of the cooperating section 1212 respectively. To enable the flat shaft 1211 to be stably kept to be inserted into the cooperating hole 21 or moved out of the cooperating hole 21, the tensioning structure 10 further includes a positioning structure 14 arranged between the cooperating section 1212 and the base 11. The positioning structure 14 enables the flat shaft 1211 to be kept at an insertion position for insertion into the cooperating hole 21 or a move-out position for movement out of the cooperating hole 21.

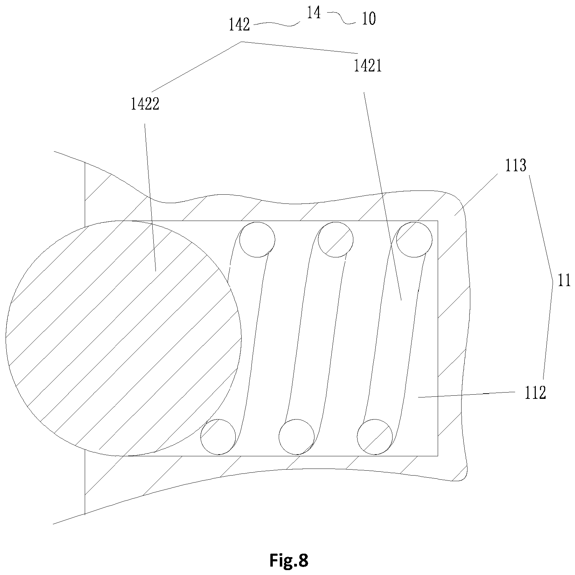

As shown in Figs. 4-8, the positioning structure 14 includes a positioning member 142, a first positioning hole 141 and a second positioning hole 143. The first positioning hole 141 is located between the second positioning hole 143 and the flat shaft 1211, and the cooperating section 1212 is provided with the first positioning hole 141 and the second positioning hole 143. The base 11 is provided with the positioning member 142. When the positioning member 142 matches the first positioning hole 141, the flat shaft 1211 is kept at the insertion position, and when the positioning member 142 matches the second positioning hole 143, the flat shaft 1211 is kept at the move-out position. In this way, when the positioning member 142 matches the first positioning hole 141, the flat shaft 1211 is capable of being stably kept at the insertion position, and when the positioning member 142 matches the second positioning hole 143, the flat shaft 1211 is capable of being stably kept at the move-out position. The positioning member 142 matches the first positioning hole 141 and the second positioning hole 143, so that the positioning structure 14 has a simple structure and is economical.

As shown in Figs. 4-8, the positioning structure 14 further includes a limiting hole 112 provided on the base 11. The positioning member 142 includes an elastic member 1421 and a positioning ball 1422 which are mounted in the limiting hole 112. The elastic member 1421 applies an elastic force to the positioning ball 1422. In this way, the limiting hole 112 prevents the elastic member 1421 and the positioning ball 1422 from being separated from the limiting hole 112, specifically, an opening of the limiting hole 112 is provided with an arc-shaped concave cavity, the arc-shaped concave cavity is stuck at a position over a radius of the positioning ball 1422, thus effectively preventing the positioning ball 1422 from being separated from the limiting hole 112 under the action of the elastic force, and the positioning ball 1422 and a hole wall of the limiting hole 112 are capable of limiting two ends of the elastic member 1421, so as to make the elastic member 1421 stressed all the time. A diameter of the first positioning hole 141 and a diameter of the second positioning hole 143 are both smaller than that of the positioning ball 1422. When the tensioning pin 121 moves, a part of the positioning ball 1422 has a positioning position located in the first positioning hole 141 or the second positioning hole 143 and an avoiding position for avoiding the flat shaft 1211. Specifically, when the positioning member 142 matches the first positioning hole 141, a part of the positioning ball 1422 is located in the first positioning hole 141, thus limiting the cooperating section 1212 vertically and horizontally. The limiting member 13 and a part of the positioning ball 1422 work together to limit the cooperating section 1212 between the positioning ball 1422 and the limiting member 13, thus preventing the cooperating section 1212 from moving in the mounting groove. When the positioning member 142 matches the second positioning hole 143, a part of the positioning ball 1422 is located in the second positioning hole 143, thus limiting the cooperating section 1212 vertically and horizontally. The limiting member 13 and part of the positioning ball 1422 may work together to limit the cooperating section 1212 between the positioning ball 1422 and the limiting member 13, thus preventing the cooperating section 1212 from moving in the mounting groove.

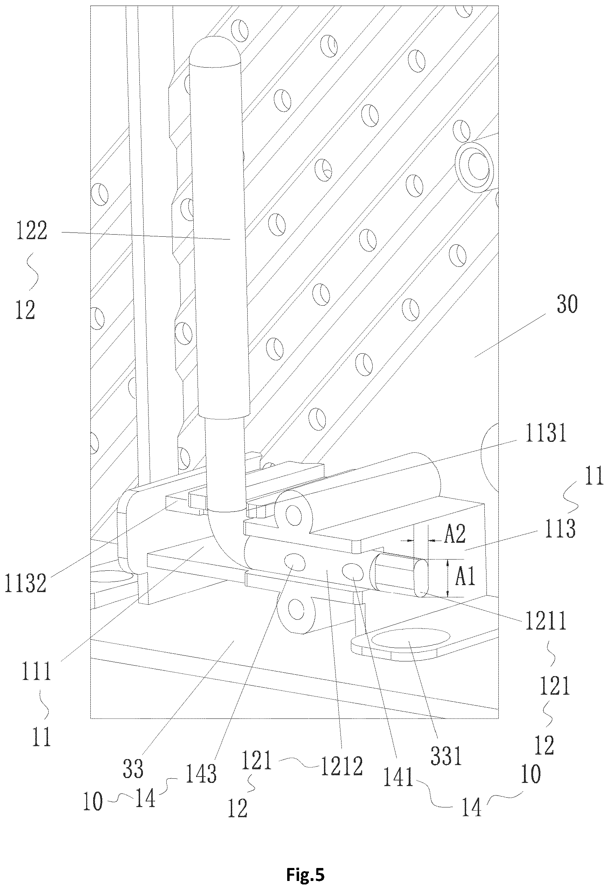

As shown in Figs. 5-7, the base 11 includes a base body 113 as well as a first avoiding notch 1131 and a second avoiding notch 1132 which are arranged on the base body 113 in a spaced manner. The first avoiding notch 1131 is located between the second avoiding notch 1132 and the flat shaft 1211, and the mounting portion 111 is arranged on the base body 113. The first avoiding notch 1131 and the second avoiding notch 1132 are both located at one side of the mounting portion 111. When a part of the operating portion 122 is located in the first avoiding notch 1131, the flat shaft 1211 is located at the insertion position, and when a part of the operating portion 122 is located in the second avoiding notch 1132, the flat shaft 1211 is located at the move-out position. In this way, both the first avoiding notch 1131 and the second avoiding notch 1132 are capable of avoiding the operating portion 122, so as to prevent the operating portion 122 from interfering with one side of the mounting portion 111, so that the operating portion 122 is capable of standing on the base body 113, an internal space of a box may be saved, and a structure in the box (such as a signal line or power line or control board) is more compact. The flat shaft 1211 switches between the insertion position and the move-out position by movement.

As shown in Figs. 5-7, to optimize a structural layout and facilitate production, manufacturing and mounting, the tensioning rod 12 is arranged in a bent manner so as to form the tensioning pin 121 and the operating portion 122. In this way, the tensioning pin 121 is rotated by the operating portion 122 in a time-saving and labor-saving manner.

As shown in Figs. 2-5, the limiting member 13 includes a limiting piece. The limiting piece has a simple structure and facilitates machining and shaping. Specifically, a side, facing the cooperating section 1212, of the limiting piece is provided with an arc-shaped groove, the arc-shaped groove matches the cooperating section 1212 in shape, under the condition that the limiting member 13 and a part of the positioning ball 1422 work together, the limiting member 13 is capable of being fitted to an outer side of the cooperating section 1212, resulting in a large contact area between the limiting member and the cooperating section and a better limiting effect.

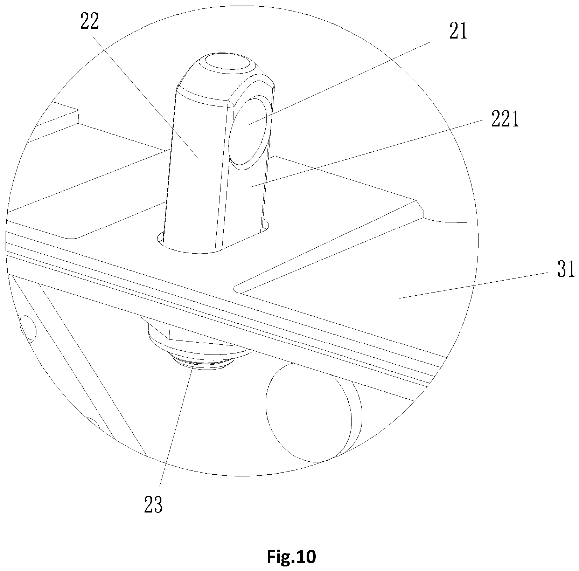

As shown in Figs. 1, 3, 10 and 11, the connecting member 20 includes a columnar section 22 and a threaded section 23 connected with the columnar section 22. A diameter of the columnar section 22 is larger than that of the threaded section 23, so that a stepped face is formed between the columnar section 22 and the threaded section 23, the stepped face is capable of being locked on a side face of a box, and the threaded section 23 is conveniently connected with a box. To connect the threaded section 23 to a box more reliably, the connecting member 20 further includes a nut matching the threaded section 23, so that the nut and the columnar section 22 are arranged on a partial structure of a box in a clamped manner. The cooperating hole 21 is provided on the columnar section 22. In the process of screwing the nut on the threaded section 23, to prevent the columnar section 22 from rotating relative to a box, the columnar section 22 is provided with a rotation stopping face 221. A torque may be further shortened when the tensioning rod is rotated, thus saving more labor during tensioning. The flat shaft 1211 is inserted into or moved out of the cooperating hole 21 smoothly, and a maximum diameter of the flat shaft 1211 is smaller than that of the cooperating hole 21. When the flat shaft 1211 is inserted into the cooperating hole 21 and the flat shaft 1211 is at the transverse unlocking position, the short axis A2 of the flat shaft 1211 is close to the top wall of the hole wall of the cooperating hole 21. The distance between the short axis A2 and the top wall of the hole wall of the cooperating hole 21 is smaller than a half of the difference between a length of the long axis A1 and a length of the short axis A2. When the flat shaft 1211 is switched from the transverse unlocking position to the vertical tensioning position, the long axis A1 of the flat shaft 1211 applies a force upwardly to the top wall of the hole wall of the cooperating hole 21.

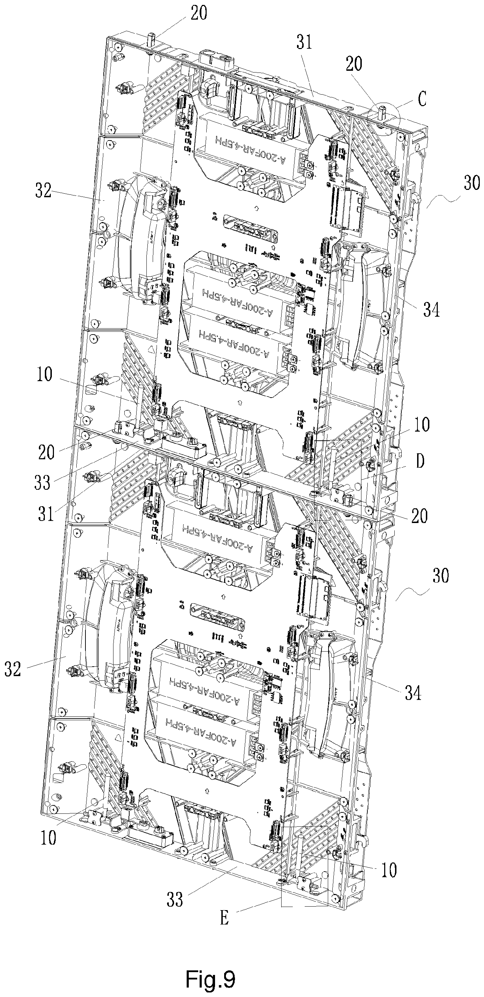

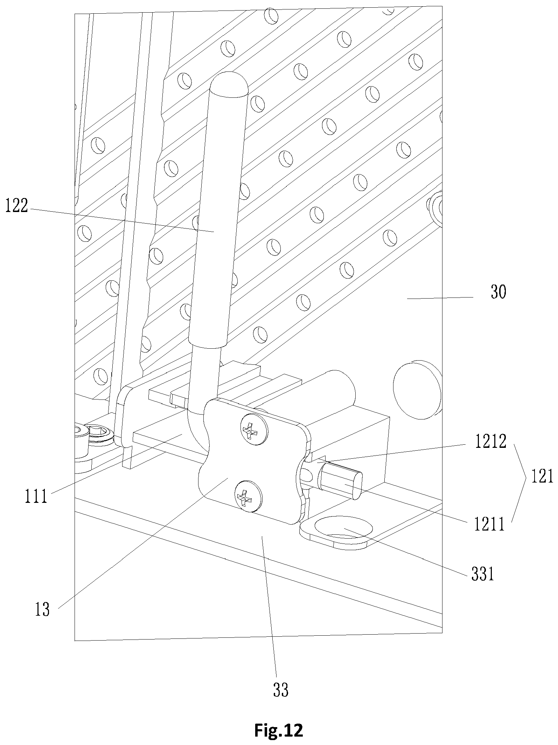

The disclosure further provides a light emitting diode (LED) box assembly. As shown in Figs. 9-12, the LED box assembly includes a plurality of boxes 30 and the above-mentioned tensioning mechanism of the box. The above-mentioned tensioning mechanism of the box may solve the problem that in the related technology, an external tool is required for tensioning two adjacent boxes close, resulting in a complex tensioning process, so the LED box assembly with the tensioning mechanism of the box may solve the same technical problem.

As shown in Figs. 9-12, two boxes 30 match each other in a spliced manner, and there are four tensioning mechanisms for boxes. Each of a first box and a second box is provided with two tensioning mechanisms of boxes. In the two boxes 30 connected one above the other, one of the boxes 30 is the first box and the other is the second box, and each of the first box and the second box includes a first side 31, a second side 32, a third side 33 and a fourth side 34 which are sequentially connected with one another. The third side 33 of the first box is connected with the first side 31 of the second box by a tensioning mechanism of a box, the tensioning structure 10 is arranged at the third side 33 of the first box, the connecting member 20 is arranged on the first side 31 of the second box in a penetrating manner, and the third side 33 of the first box is provided with an avoiding hole 331 for avoiding the connecting member 20 on the second box. The avoiding hole 331 enables the third side 33 of the first box to avoid the connecting member 20 conveniently, so that the connecting member 20 is capable of penetrating the third side 33 of the first box. Specifically, after the first box and the second box are connected one above the other, the mounting personnel pulls the operating portion 122 outward and then pushes the operating portion rightward to enable the flat shaft 1211 of the tensioning pin 121 to be completely inserted into the cooperating hole 21 of the columnar section 22, and then the mounting personnel pulls the operating portion 122 upward into the first avoiding notch 1131. In this case, the flat shaft 1211 rotates from the transverse unlocking position to the vertical tensioning position, and the tensioning mechanism of th box may draw the first box at an upper position and the second box at a lower position close. The number of boxes 30 matching one another in a spliced manner may be not limited to two, but also four, six or more. The number of tensioning mechanisms of boxes may not be limited to four, but can also be increased or decreased according to the number of boxes 30 matching one another in a spliced manner.

In the description of the present invention, it should be understood that orientations or positional relationships indicated by the terms "front, rear, upper, lower, left and right", "transverse, vertical, perpendicular, and horizontal", "top and bottom", etc. are based on the orientations or positional relationships shown in the accompanying drawings and are only for facilitating the description of the present invention and simplifying the description, and in the absence of a statement to the contrary, the orientations do not indicate or implies that a device or element referred to must have a particular orientation or be constructed and operated in a particular orientation, and therefore will not be interpreted as limiting the scope of protection of the present invention; and the words "inside and outside" refer to inside and outside relative to an outline of each component itself.

For ease of description, spatial relative terms such as "over", "above", "on an upper surface" and "on" may be used herein to describe spatial positional relations of one device or feature with other devices or features as shown in the drawings. It should be understood that the spatial relative terms are intended to include different orientations in use or operation in addition to the orientation of the device described in the drawings. For example, if the device in the drawings is inverted, the device described as "above" or "over" other devices or structures would then be positioned "below" or "under" the other devices or structures. Thus the exemplary term "above" may include two orientations of "above" and "below." The device may also be positioned (rotated 90 degrees or at other orientations) in other different ways and the spatial relative description used herein is interpreted accordingly.

In addition, it should be noted that words "first" and "second" are used to define parts only for convenience of distinguishing corresponding parts. Unless otherwise stated, the above words have no special meaning, so they cannot be understood as limiting the scope of protection of the present invention.

The above has been described only as preferred embodiments of the present invention and is not intended to limit the present invention, which can be modified and changed, for those skilled in the art.

## Claims

1. A tensioning mechanism of a box, comprising:
a tensioning structure (10) comprising a base (11) and a tensioning rod (12), wherein the base (11) is provided with a mounting portion (111), the tensioning rod (12) comprises a tensioning pin (121) and an operating portion (122) connected with the tensioning pin (121), and the tensioning pin (121) is movably arranged penetrating through the mounting portion; and
a connecting member (20), wherein the connecting member (20) is provided with a cooperating hole (21),
wherein the tensioning pin (121) comprises a flat shaft (1211), the flat shaft (1211) is able to being inserted into or moved out of the cooperating hole (21), and under the condition that the flat shaft (1211) is inserted into the cooperating hole (21), the flat shaft (1211) has a vertical tensioning position and a transverse unlocking position;
**characterized in that**, the tensioning pin (121) further comprises a cooperating section (1212) arranged between the flat shaft (1211) and the operating portion (122), the tensioning structure (10) further comprises a positioning structure (14) arranged between the cooperating section (1212) and the base (11), and the positioning structure (14) enables the flat shaft (1211) to be kept at an insertion position for inserting into the cooperating hole (21) or a move-out position for moving out of the cooperating hole (21), the positioning structure (14) comprises a positioning member (142), a first positioning hole (141) and a second positioning hole (143), the first positioning hole (141) is located between the second positioning hole (143) and the flat shaft (1211), the cooperating section (1212) is provided with the first positioning hole (141) and the second positioning hole (143), the base (11) is provided with the positioning member (142), when the positioning member (142) cooperates the first positioning hole (141), the flat shaft (1211) is kept at the insertion position, and when the positioning member (142) cooperates the second positioning hole (143), the flat shaft (1211) is kept at the move-out position.

2. The tensioning mechanism of the box as claimed as claim 1, wherein the mounting portion (111) is a mounting groove, the tensioning structure (10) further comprises a limiting member (13), and the limiting member (13) is connected with the base (11) and located at an opening of the mounting groove.

3. The tensioning mechanism of a box as claimed as claim 1, wherein the positioning structure (14) further comprises a limiting hole (112) provided on the base (11), the positioning member (142) comprises an elastic member (1421) and a positioning ball (1422) which are mounted in the limiting hole (112), the elastic member (1421) applies an elastic force to the positioning ball (1422), a diameter of the first positioning hole (141) and a diameter of the second positioning hole (143) are both smaller than a diameter of the positioning ball (1422), and when the tensioning pin (121) moves, a part of the positioning ball (1422) has a positioning position located in the first positioning hole (141) or the second positioning hole (143) and an avoiding position for avoiding the flat shaft (1211).

4. The tensioning mechanism of a box as claimed as claim 1, wherein the base (11) comprises a base body (113) as well as a first avoiding notch (1131) and a second avoiding notch (1132) which are arranged on the base body (113) in a spaced manner, the first avoiding notch (1131) is located between the second avoiding notch (1132) and the flat shaft (1211), the mounting portion (111) is arranged on the base body (113), the first avoiding notch (1131) and the second avoiding notch (1132) are both located at one side of the mounting portion (111), when a part of the operating portion (122) is located in the first avoiding notch (1131), the flat shaft (1211) is located at the insertion position, and when a part of the operating portion (122) is located in the second avoiding notch (1132), the flat shaft (1211) is located at the move-out position.

5. The tensioning mechanism of a box as claimed as claim 2, wherein the tensioning rod (12) is arranged in a bent manner so as to form the tensioning pin (121) and the operating portion (122); and the limiting member (13) comprises a limiting piece.

6. The tensioning mechanism of a box as claimed as claim 1, wherein the connecting member (20) comprises a columnar section (22) and a threaded section (23) connected with the columnar section (22), a diameter of the columnar section (22) is larger than a diameter of the threaded section (23), the cooperating hole (21) is provided on the columnar section (22), the columnar section (22) is provided with a rotation stopping face (221), and a diameter of the flat shaft (1211) is smaller than a diameter of the cooperating hole (21).

7. A light emitting diode (LED) box assembly, comprising a plurality of boxes (30) and the tensioning mechanism of the box as claimed as any one of claims 1-6.

8. The LED box assembly as claimed as claim 7, wherein
the plurality of boxes (30) cooperate one another in a spliced manner, there are a plurality of tensioning mechanisms for boxes, in the two boxes (30) connected one above the other, one of the boxes (30) is a first box and the other is a second box, and each of the first box and the second box comprises a first side (31), a second side (32), a third side (33) and a fourth side (34) which are sequentially connected with one another; and
the third side (33) of the first box is connected with the first side (31) of the second box by one of the tensioning mechanisms for boxes, the tensioning structure (10) is arranged at the third side (33) of the first box, the connecting member (20) is arranged on the first side (31) of the second box in a penetrating manner, and the third side (33) of the first box is provided with an avoiding hole (331) for avoiding the connecting member (20) on the second box.

## Patentansprüche

1. Spannmechanismus einer Box, umfassend:
eine Spannstruktur (10), die eine Basis (11) und eine Spannstange (12) umfasst, wobei die Basis (11) mit einem Montageabschnitt (111) bereitgestellt ist, die Spannstange (12) einen Spannstift (121) und einen Betätigungsabschnitt (122), der mit dem Spannstift (121) verbunden ist, umfasst, und der Spannstift (121) durch den Montageabschnitt eindringend bewegbar eingerichtet ist; und
ein Verbindungselement (20), wobei das Verbindungselement (20) mit einem zusammenwirkenden Loch (21) bereitgestellt ist,
wobei der Spannstift (121) einen flachen Schaft (1211) umfasst, der flache Schaft (1211) in der Lage ist, in das zusammenwirkende Loch (21) eingesetzt oder daraus herausbewegt zu werden, und unter der Bedingung, dass der flache Schaft (1211) in das zusammenwirkende Loch (21) eingesetzt ist, der flache Schaft (1211) eine vertikale Spannposition und eine Querentriegelungsposition aufweist;
**dadurch gekennzeichnet, dass** der Spannstift (121) weiter einen zusammenwirkenden Teilabschnitt (1212) umfasst, der zwischen der flachen Welle (1211) und dem Betätigungsabschnitt (122) eingerichtet ist, die Spannstruktur (10) weiter eine Positionierungsstruktur (14) umfasst, die zwischen dem zusammenwirkenden Teilabschnitt (1212) und der Basis (11) eingerichtet ist, und die Positionierungsstruktur (14) es ermöglicht, die flache Welle (1211) in einer Einsetzposition zum Einsetzen in das zusammenwirkende Loch (21) oder einer Herausbewegungsposition zum Herausbewegen aus dem zusammenwirkenden Loch (21) zu halten, die Positionierungsstruktur (14) ein Positionierungselement (142), ein erstes Positionierungsloch (141) und ein zweites Positionierungsloch (143) umfasst, sich das erste Positionierungsloch (141) zwischen dem zweiten Positionierungsloch (143) und dem flachen Schaft (1211) befindet, der zusammenwirkende Teilabschnitt (1212) mit dem ersten Positionierungsloch (141) und dem zweiten Positionierungsloch (143) bereitgestellt ist, die Basis (11) mit dem Positionierungselement (142) bereitgestellt ist, wenn das Positionierungselement (142) mit dem ersten Positionierungsloch (141) zusammenwirkt, der flache Schaft (1211) an der Einsetzposition gehalten wird, und wenn das Positionierungselement (142) mit dem zweiten Positionierungsloch (143) zusammenwirkt, der flache Schaft (1211) in der Hausbewegungsposition gehalten wird.

2. Spannmechanismus der Box nach Anspruch 1, wobei der Montageabschnitt (111) eine Montagenut ist, die Spannstruktur (10) weiter ein Begrenzungselement (13) umfasst, und das Begrenzungselement (13) mit der Basis (11) verbunden ist und sich an einer Öffnung der Montagenut befindet.

3. Spannmechanismus einer Box nach Anspruch 1, wobei die Positionierungsstruktur (14) weiter ein Begrenzungsloch (112) umfasst, das an der Basis (11) bereitgestellt ist, das Positionierungselement (142) ein elastisches Element (1421) und eine Positionierungskugel (1422) umfasst, die in dem Begrenzungsloch (112) montiert sind, das elastische Element (1421) eine elastische Kraft auf die Positionierungskugel (1422) anlegt, ein Durchmesser des ersten Positionierungslochs (141) und ein Durchmesser des zweiten Positionierungslochs (143) beide kleiner als ein Durchmesser der Positionierungskugel (1422) sind, und wenn sich der Spannstift (121) bewegt, ein Teil der Positionierungskugel (1422) eine Positionierungsposition aufweist, die sich in dem ersten Positionierungsloch (141) oder dem zweiten Positionierloch (143) befindet und eine Vermeidungsposition zum Vermeiden des flachen Schafts (1211).

4. Spannmechanismus einer Box nach Anspruch 1, wobei die Basis (11) einen Basiskörper (113) sowie eine erste Vermeidungskerbe (1131) und eine zweite Vermeidungskerbe (1132) umfasst, die an dem Basiskörper (113) in einer beabstandeten Weise eingerichtet sind, sich die erste Vermeidungskerbe (1131) zwischen der zweiten Vermeidungskerbe (1132) und der flachen Welle (1211) befindet, der Montageabschnitt (111) an dem Basiskörper (113) eingerichtet ist, sich die erste Vermeidungskerbe (1131) und die zweite Vermeidungskerbe (1132) beide an der Seite des Montageabschnitt (111) befinden, wenn sich ein Teil des Betätigungsabschnitts (122) in der ersten Vermeidungskerbe (1131) befindet, sich die flache Welle (1211) an der Einsatzposition befindet, und wenn sich ein Teil des Betätigungsabschnitts (122) in der zweiten Vermeidungskerbe (1132) befindet, sich die flache Welle (1211) an der Herausbewegungsposition befindet.

5. Spannmechanismus einer Box nach Anspruch 2, wobei die Spannstange (12) in einer gebogenen Weise eingerichtet ist, um den Spannstift (121) und den Betätigungsabschnitt (122) zu bilden; und das Begrenzungselement (13) ein Begrenzungsstück umfasst.

6. Spannmechanismus einer Box nach Anspruch 1, wobei das Verbindungselement (20) einen säulenförmigen Teilabschnitt (22) und einen Gewindeteilabschnitt (23), der mit dem säulenförmigen Teilabschnitt (22) verbunden ist, umfasst, ein Durchmesser des säulenförmigen Teilabschnitts (22) größer als ein Durchmesser des Gewindeteilabschnitts (23) ist, das zusammenwirkende Loch (21) an dem säulenförmigen Teilabschnitt (22) bereitgestellt ist, der säulenförmige Teilabschnitt (22) mit einer Drehstoppfläche (221) bereitgestellt ist, und ein Durchmesser der flachen Welle (1211) kleiner als ein Durchmesser des zusammenwirkenden Lochs (21) ist.

7. Leuchtdioden-Boxanordnung (LED-Boxanordnung), die eine Vielzahl von Boxen (30) und den Spannmechanismus der Box nach einem der Ansprüche 1-6 umfasst.

8. LED-Boxanordnung nach Anspruch 7, wobei
die Vielzahl von Boxen (30) miteinander in einer gespleißten Art zusammenwirkt, es eine Vielzahl von Spannmechanismen für Boxen gibt, in den zwei übereinander verbundenen Boxen (30) eine der Boxen (30) eine erste Box und die andere eine zweite Box ist, und jede der ersten Box und der zweiten Box eine erste Seite (31), eine zweite Seite (32), eine dritte Seite (33) und eine vierte Seite (34) umfasst, die sequenziell miteinander verbunden sind; und
die dritte Seite (33) der ersten Box mit der ersten Seite (31) der zweiten Box durch einen der Spannmechanismen für Boxen verbunden ist, die Spannstruktur (10) an der dritten Seite (33) der ersten Box eingerichtet ist, das Verbindungselement (20) an der ersten Seite (31) der zweiten Box in einer eindringenden Weise eingerichtet ist, und die dritte Seite (33) der ersten Box mit einem Vermeidungsloch (331) zum Vermeiden des Verbindungselements (20) an der zweiten Box bereitgestellt ist.

## Revendications

1. Mécanisme de mise en tension d'un boîtier, comprenant :
une structure de mise en tension (10) comprenant une base (11) et une tige de mise en tension (12), dans lequel la base (11) est pourvue d'une partie de montage (111), la tige de mise en tension (12) comprend une broche de mise en tension (121) et une partie de fonctionnement (122) reliée à la broche de mise en tension (121), et la broche de mise en tension (121) est agencée de manière mobile en pénétrant à travers la partie de montage ; et
un élément de liaison (20), dans lequel l'élément de liaison (20) est pourvu d'un trou de coopération (21),
dans lequel la broche de mise en tension (121) comprend un arbre plat (1211), l'arbre plat (1211) peut être inséré dans le trou de coopération (21), ou retiré de celui-ci, et à condition que l'arbre plat (1211) soit inséré dans le trou de coopération (21), l'arbre plat (1211) a une position de mise en tension verticale et une position de déverrouillage transversale ;
**caractérisé en ce que** la broche de mise en tension (121) comprend également une section de coopération (1212) agencée entre l'arbre plat (1211) et la partie de fonctionnement (122), la structure de mise en tension (10) comprend également une structure de positionnement (14) agencée entre la section de coopération (1212) et la base (11), et la structure de positionnement (14) permet à l'arbre plat (1211) d'être maintenu au niveau d'une position d'insertion pour l'insertion dans le trou de coopération (21) ou d'une position de retrait pour le retrait du trou de coopération (21), la structure de positionnement (14) comprend un élément de positionnement (142), un premier trou de positionnement (141) et un second trou de positionnement (143), le premier trou de positionnement (141) est situé entre le second trou de positionnement (143) et l'arbre plat (1211), la section de coopération (1212) est pourvue du premier trou de positionnement (141) et du second trou de positionnement (143), la base (11) est pourvue de l'élément de positionnement (142), lorsque l'élément de positionnement (142) coopère avec le premier trou de positionnement (141), l'arbre plat (1211) est maintenu au niveau de la position d'insertion, et lorsque l'élément de positionnement (142) coopère avec le second trou de positionnement (143), l'arbre plat (1211) est maintenu au niveau de la position de retrait.

2. Mécanisme de mise en tension du boîtier selon la revendication 1, dans lequel la partie de montage (111) est une rainure de montage, la structure de mise en tension (10) comprend également un élément de limitation (13), et l'élément de limitation (13) est relié à la base (11) et situé au niveau d'une ouverture de la rainure de montage.

3. Mécanisme de mise en tension d'un boîtier selon la revendication 1, dans lequel la structure de positionnement (14) comprend également un trou de limitation (112) prévu au niveau de la base (11), l'élément de positionnement (142) comprend un élément élastique (1421) et une bille de positionnement (1422) qui sont montés dans le trou de limitation (112), l'élément élastique (1421) applique une force élastique sur la bille de positionnement (1422), un diamètre du premier trou de positionnement (141) et un diamètre du second trou de positionnement (143) sont tous deux inférieurs à un diamètre de la bille de positionnement (1422), et lorsque la broche de mise en tension (121) se déplace, une partie de la bille de positionnement (1422) a une position de positionnement située dans le premier trou de positionnement (141) ou le second trou de positionnement (143) et une position d'évitement pour éviter l'arbre plat (1211).

4. Mécanisme de mise en tension d'un boîtier selon la revendication 1, dans lequel la base (11) comprend un corps de base (113) ainsi qu'une première encoche d'évitement (1131) et une seconde encoche d'évitement (1132) qui sont agencées sur le corps de base (113) de manière espacée, la première encoche d'évitement (1131) est située entre la seconde encoche d'évitement (1132) et l'arbre plat (1211), la partie de montage (111) est agencée sur le corps de base (113), la première encoche d'évitement (1131) et la seconde encoche d'évitement (1132) sont toutes deux situées au niveau d'un côté de la partie de montage (111), lorsqu'une partie de la partie de fonctionnement (122) est située dans la première encoche d'évitement (1131), l'arbre plat (1211) est situé au niveau de la position d'insertion, et lorsqu'une partie de la partie de fonctionnement (122) est située dans la seconde encoche d'évitement (1132), l'arbre plat (1211) est situé au niveau de la position retrait.

5. Mécanisme de mise en tension d'un boîtier selon la revendication 2, dans lequel la tige de mise en tension (12) est agencée de manière courbée de sorte à former la broche de mise en tension (121) et la partie de fonctionnement (122) ; et l'élément de limitation (13) comprend une pièce de limitation.

6. Mécanisme de mise en tension d'un boîtier selon la revendication 1, dans lequel l'élément de liaison (20) comprend une section colonnaire (22) et une section filetée (23) reliée à la section colonnaire (22), un diamètre de la section colonnaire (22) est supérieur à un diamètre de la section filetée (23), le trou de coopération (21) est prévu dans la section colonnaire (22), la section colonnaire (22) est pourvue d'une face d'arrêt de rotation (221), et un diamètre de l'arbre plat (1211) est inférieur à un diamètre du trou de coopération (21).

7. Ensemble boîtier de diode électroluminescente (DEL), comprenant une pluralité de boîtiers (30) et le mécanisme de mise en tension du boîtier selon l'une quelconque des revendications 1 à 6.

8. Ensemble boîtier de DEL selon la revendication 7, dans lequel la pluralité de boîtiers (30) coopèrent entre eux de manière emboîtable, il existe une pluralité de mécanismes de mise en tension pour boîtiers, dans les deux boîtiers (30) reliés l'un au-dessus de l'autre, l'un des boîtiers (30) est un premier boîtier et l'autre est un second boîtier, et chacun du premier boîtier et du second boîtier comprend un premier côté (31), un deuxième côté (32), un troisième côté (33) et un quatrième côté (34) qui sont reliés successivement les uns aux autres ; et
le troisième côté (33) du premier boîtier est relié au premier côté (31) du second boîtier par l'un des mécanismes de mise en tension pour boîtiers, la structure de mise en tension (10) est agencée au niveau du troisième côté (33) du premier boîtier, l'élément de liaison (20) est agencé sur le premier côté (31) du second boîtier de manière pénétrante, et le troisième côté (33) du premier boîtier est pourvu d'un trou d'évitement (331) pour éviter l'élément de liaison (20) sur le second boîtier.
